# EUROPEAN PATENT SPECIFICATION

(11) **EP 0 820 133 B1**
(45) Date of publication and mention of the grant of the patent: **14.05.2003**
(21) Application number: 97305110.5
(22) Date of filing: 10.07.1997
(51) Int. Cl.: H01S 3/13, H04B 10/18, H04B 10/145, G02F 1/21

(54) **Optical etalon arrangement**
Optische Etalonanordnung
Dispositif étalon optique

(30) Priority: 20.07.1996 GB 9615302; 28.04.1997 CA 2203845; 30.04.1997 US 848337; 04.07.1997 JP 17976697
(43) Date of publication of application: 21.01.1998
(73) Proprietor: Nortel Networks Limited, Montreal, Quebec H2Y 3Y4 (CA)
(72) Inventor: Epworth, Richard Edward, Sawbridgeworth, Herts CM21 0BD (GB)
(74) Representative: Clayton-Hathway, Anthony Nicholas

(56) References cited:
- GB-A- 2 075 746
- US-A- 4 434 490
- US-A- 4 508 964
- US-A- 5 173 908
- US-A- 5 523 874

## Description

This invention relates to control systems for etalon arrangements to Fabry Perot dispersion compensators, to control systems for controlling the wavelength of a laser according to the output of an etalon arrangement, and to methods of transmitting data in an optical transmission system.

With the advent of optical amplifiers which can compensate for fibre loss, the reach of fibre systems at 10Gb/s and beyond, is limited by chromatic dispersion. Chromatic dispersion causes different parts of the signal spectrum to arrive at the distant end of the system at different times. An optical signal carrying information has a finite bandwidth (spread in wavelengths). If these propagate at different velocities along the fibre, the narrow pulses will be dispersed. The dominant cause of chromatic dispersion is material dispersion, the variation in the refractive index versus wavelength of silica, the basic material from which all low loss transmission fibres are made.

Chromatic dispersion is a potentially reversible process, because the optical frequency of any part of the signal contains the information of the delay it has suffered. Optical dispersion compensation requires an element which can produce a delay versus frequency characteristic equal and opposite to that of the fibre. It may be optically compensated either by using special dispersion shifted transmission fibre in the transmission path or by localised dispersion compensation (equalisation).

One method of providing such compensation is to use an etalon. Such devices have a sharp response at resonant frequencies, which makes them suitable as filters. They also give a variable amount of dispersion, and so have been used as dispersion compensators. The Fabry Perot etalon is one example, which will be discussed in more detail.

US Patent No 4,508,964 discloses a tunable Fabry-Perot filter.

Although a Fabry Perot etalon can be tuned across the full Erbium amplifier wavelength response window, it is a narrow band solution and one device can only compensate for the dispersion in a single specific wavelength channel. However it does offer low loss, small size and low cost. The particular advantage is that the compensation is easily adjustable by varying the tuning. This factor will become of greater importance in the future, as systems are required to operate over longer distances, and higher bit rates.

US Patent No 5,173,908 discloses a control means for an etalon arrangement. US Patent No 4,434,490 discloses a method for removing the dependence of the control system on the signal power.

The main problem with the etalon dispersion compensator can be summarised as follows:

There is no reliable control system which will stabilise the dispersion over many years, despite any drift in device parameters which might occur (e.g. piezoelectric sensitivity, fibre input/output/monitor coupling efficiency monitor detector leakage current, or mirror finesse).

The invention aims to provide improved systems and methods.

According to one aspect of the invention, there is provided a control system for an etalon arrangement comprising a pair of reflecting surfaces arranged in parallel, at least one of which is partially reflecting, said partially reflecting surface transmitting a monitoring signal, the control system comprising:
means for monitoring the monitoring signal output power;
a dither generator to apply a dither to the wavelength response of the etalon arrangement or to the wavelength of a signal source upstream of the etalon arrangement; and
means for controlling the wavelength response of the arrangement, said means comprising:
   a derivative generator for generating first and second order derivatives of the monitoring signal output power, with respect to the wavelength of said monitoring signal; and
   an offset generator deriving from the ratio of said derivatives an offset signal, the offset signal adjusting the wavelength response of the arrangement.

According to another aspect of the invention, there is provided a control system for controlling an output wavelength of a transmitter laser in an optical transmission system which comprises an etalon arrangement downstream of the laser, the control system comprising:
means for monitoring the monitoring signal output power;
a dither generator to apply a dither to transmitter; and
means for controlling the wavelength response of the arrangement, said means comprising:
   a derivative generator for generating first and second order derivatives of the monitoring signal output power, with respect to the wavelength of said monitoring signal; and
   an offset generator deriving from the ratio of said derivatives an offset signal, the offset signal adjusting the wavelength response of the arrangement.

According to another aspect of the invention, there is provided a Fabry Perot etalon dispersion compensator comprising:
an etalon arrangement comprising
a pair of reflecting surfaces arranged in parallel, at least one of which is partially reflecting, said partially reflecting surface transmitting a monitoring signal;
means for monitoring the monitoring signal output power;
a dither generator to apply a dither to the wavelength response of the etalon arrangement; and
control means to control the wavelength response of the compensator so as to maintain the dispersion of the compensator substantially independent of input power variations and characteristics of the monitoring means, said control means comprising:
   a derivative generator for generating first and second order derivatives of the monitoring signal output power, with respect to the wavelength of said monitoring signal; and
   an offset generator deriving from the ratio of said derivatives an offset signal, the offset signal adjusting the wavelength response of the arrangement.

According to another aspect of the invention, there is provided a method of transmitting data in an optical transmission system comprising a source transmitter and an etalon arrangement, the method comprising the steps of:
applying a dither to either the output wavelength of the transmitter or the wavelength response of the etalon arrangement;
monitoring the output power of the etalon arrangement;
calculating a ratio of derivatives with respect to wavelength, of the monitored output; and
generating an offset signal for controlling the output wavelength of the transmitter, or the wavelength response of the etalon arrangement, on the basis of the ratio of the derivatives.

Preferred features are set out in dependent claims. Such features may be combined in any manner as required. For a better understanding of the invention, and to show by way of example how the same may be carried into effect, embodiments of the invention will now be described, with reference to the drawings in which:
- Figure 1: shows a schematic diagram of an optical fibre transmission system incorporating features of the invention;
- Figure 2 to 4: show in schematic form alternative implementations of the system of figure 1;
- Figure 5: shows the response of two etalons in terms of delay against wavelength; and
- Figures 6 to 11: show graphs of wavelength response, and derivatives for etalons of various values of finesse.

### Detailed Description:

The basic Fabry-Perot etalon is an all pass device, i.e. varying the tuning varies the dispersion but not the power transmitted or reflected. It also has a multiplicity of very narrow resonances. One major uncertainty is whether the compensator can be locked to the correct operating point, reliably over life. In principle it would be possible to derive a control signal from the regenerator, by monitoring the eye shape. This is analogous to an autofocus camera which adjusts to maximum sharpness. This embodiment of the invention would be more difficult to implement with sufficient accuracy than the possibility of locking to the signal power, as will be described herein.

To implement the monitoring means, one way is to make the second mirror slightly transparent. The effect of this is to produce a small dip in the signal power (at the output port), as the etalon is tuned through resonance. While this alone could be monitored, a higher contrast signal is available by providing an additional monitor port, using the signal passing through the second mirror.

Similar high finesse etalons have been used for narrow band filters. These can be stabilised to the signal by applying dither to the etalon (via. piezoelectric control elements), and feeding back to stabilise on the peak (by forcing the demodulated dither component to zero). For an etalon dispersion compensator, it has been necessary to provide an offset voltage in the control loop to enable locking to a point away from the peak. This technique requires a reference signal for the signal power, as without such reference, the operating point would vary rapidly with optical power level. One way of implementing this is to simply control to a fixed ratio of monitor to input (or output) power. This however is reliant on the long term stability of the device. In the ideal situation the fibre coupling efficiencies and mirror reflectivities all stay constant, but this may not be the case in practice. There must be some questions of the stability of any bulk optic component. Accordingly, the invention provides a locking technique which uses the monitor, yet can stabilise the dispersion for a wide range of coupling and loss variations, and input powers.

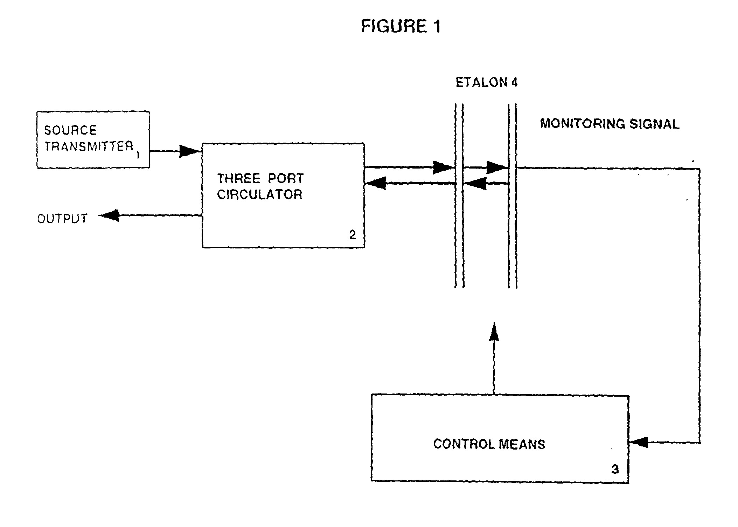

Figure 1 shows an optical transmission system incorporating an embodiment of the control system of the invention. A source transmitter 1, for example a laser transmitter, feeds a three port circulator 2, which in turn feeds an etalon 4 controlled by a control means 3. The laser transmitter includes a modulation means, eg for direct modulation or external modulation.

The etalon 4 is shown as a reflective device, though the invention is applicable to transmissive devices. The three port circulator separates the output which can be fed to a receiver. The etalon or multiple etalon scan be located anywhere in the optical path.

A monitoring signal is derived from the etalon, preferably by making the reflecting face of the etalon slightly transmissive. This monitoring signal is fed back to the control means to facilitate locking.

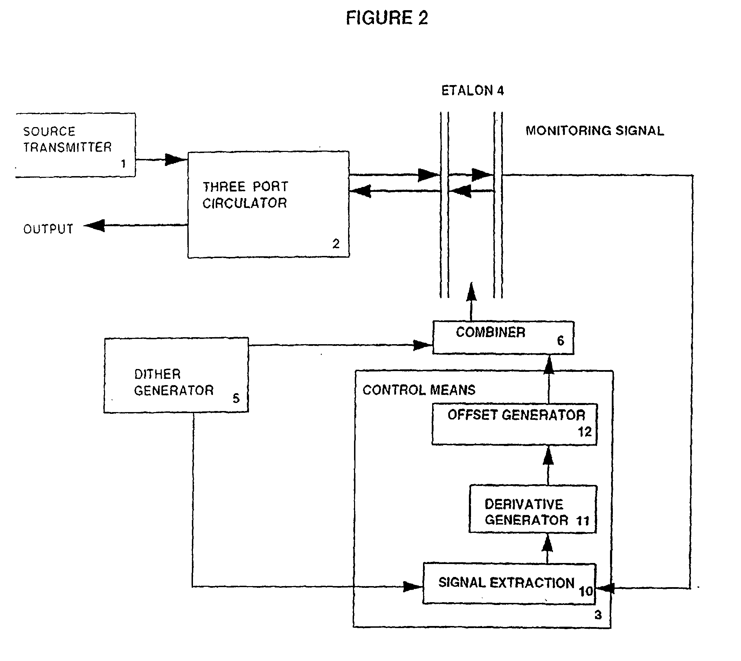

Figure 2 shows one possible implementation of the system of figure 1. A dither generator 5 is provided for applying a dither to the response of the etalon 4. Preferably the dither is relatively low frequency, so that the signal extraction from the monitoring signal can be carried out using relatively low speed circuitry which is simpler and cheaper.

The change in response of the etalon can be achieved by changing the spacing of the two reflective surfaces, for example by means of a Piezo-Electric element. The dither signal can be combined with a DC offset signal, as shown by the combiner element 6 in figure 2, the output of which is used to control the spacing of the etalon.

The control means 3 as shown in figure 2, comprises a signal extraction function 10, which extracts the portion of the monitoring signal which is attributable to the dither signal. This can be done either by narrow band filtering, or by a synchronous detection circuit. A derivative generator 11 generates a second order derivative with respect to wavelength, and a first order derivative with respect to wavelength. from the monitoring signal.

By only using derivatives, the system is immune to errors such as those due to detector leakage currents.

From these derivatives, the optimum offset is determined, by means of the offset generator 12, and fed to the etalon. The functions of the signal extraction, generation of the derivatives, and derivation of the offset, can be carried out in a digital signal processor, or by use of conventional analogue circuitry.

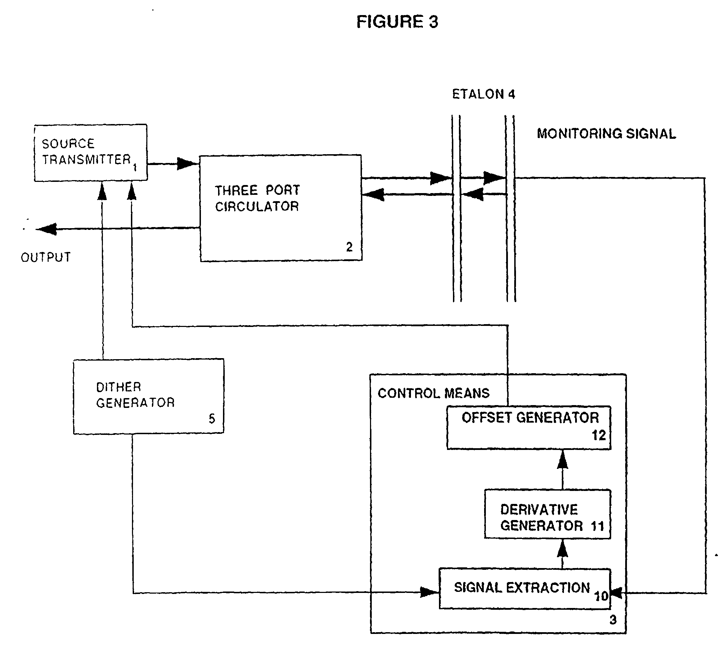

Figure 3 shows a variation in which the dither is applied to the source transmitter 1. Furthermore, instead of locking the etalon response to the wavelength of the source transmitter, in the embodiment of figure 3, the wavelength of the transmitter is locked to that of the etalon resonance. The basic control principles as described in relation to figure 2 can be applied in a similar way in figure 3. By this means, the etalon can be a stable cavity which is used as a wavelength reference for the laser.

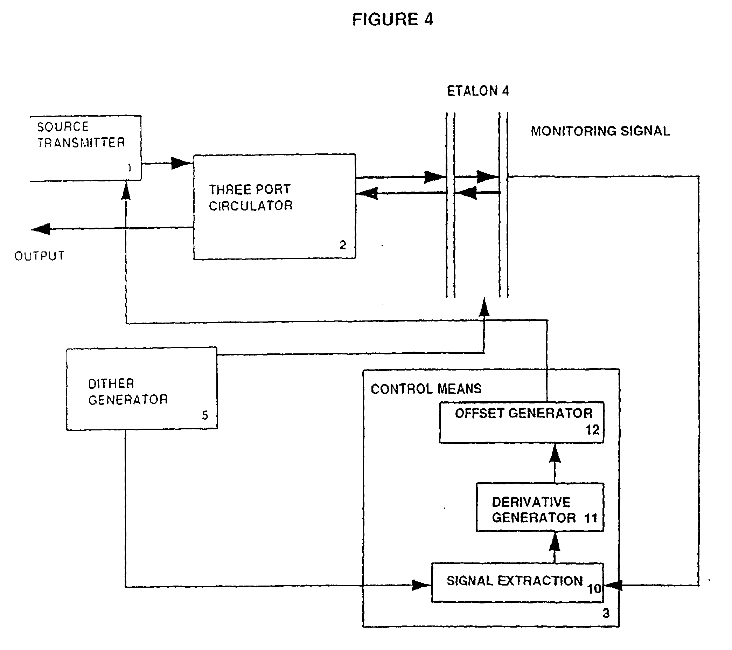

Another alternative is shown in figure 4. Here the dither is applied to the etalon, while the offset is applied to the source transmitter 1, to lock it to the etalon response. Again, the basic control principles set out for figure 2 can be applied equally to the arrangement of figure 4.

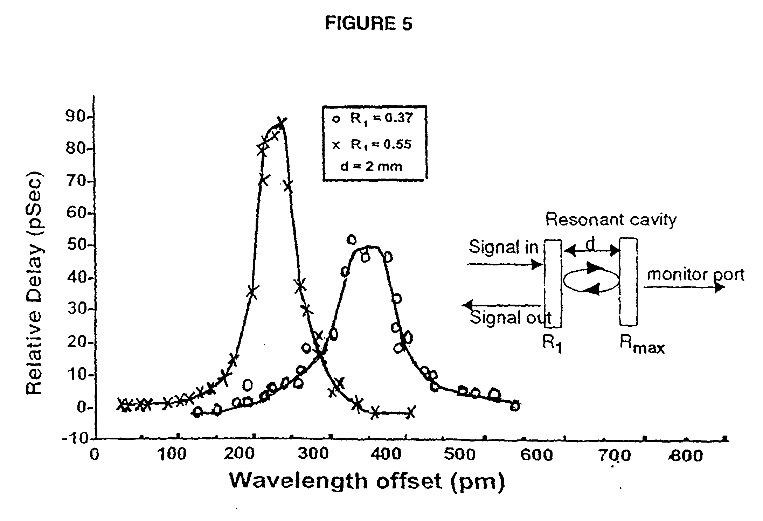

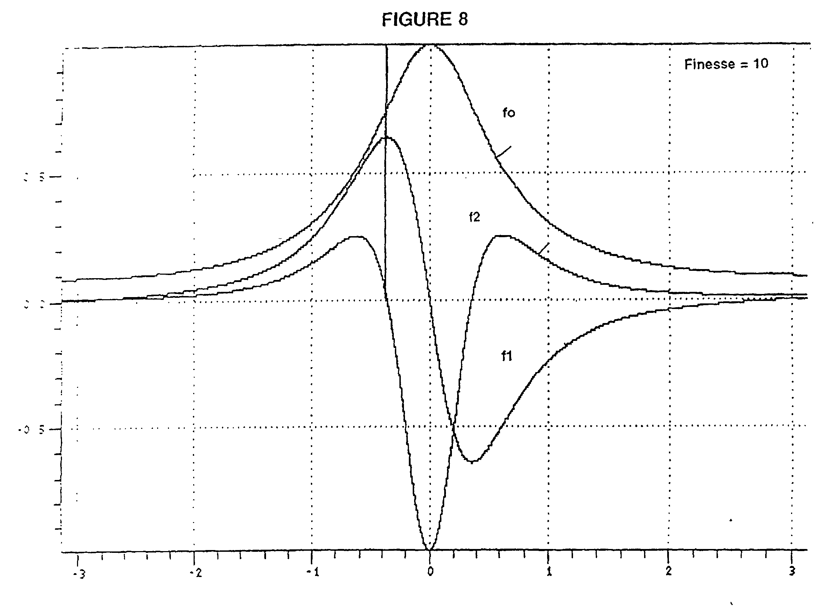

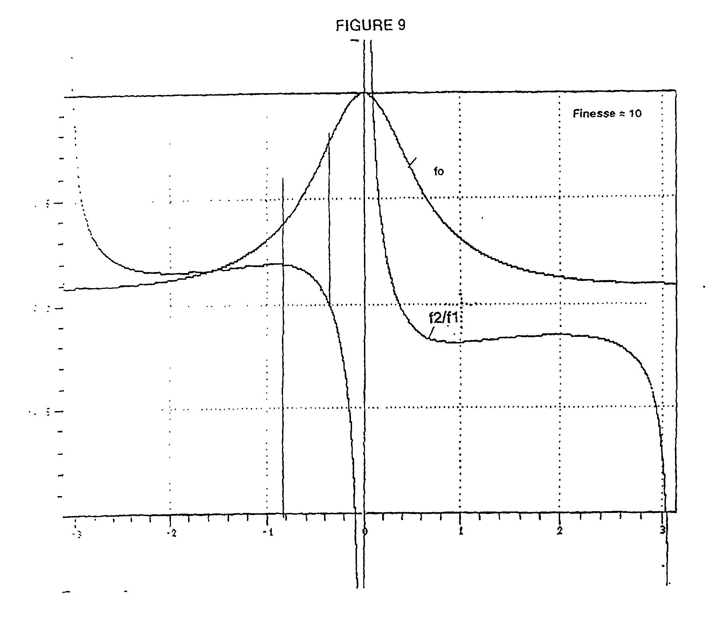

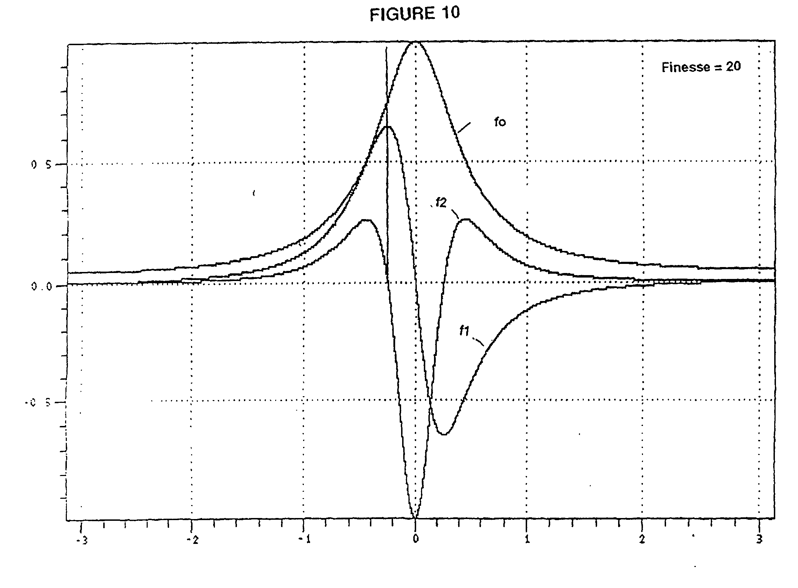

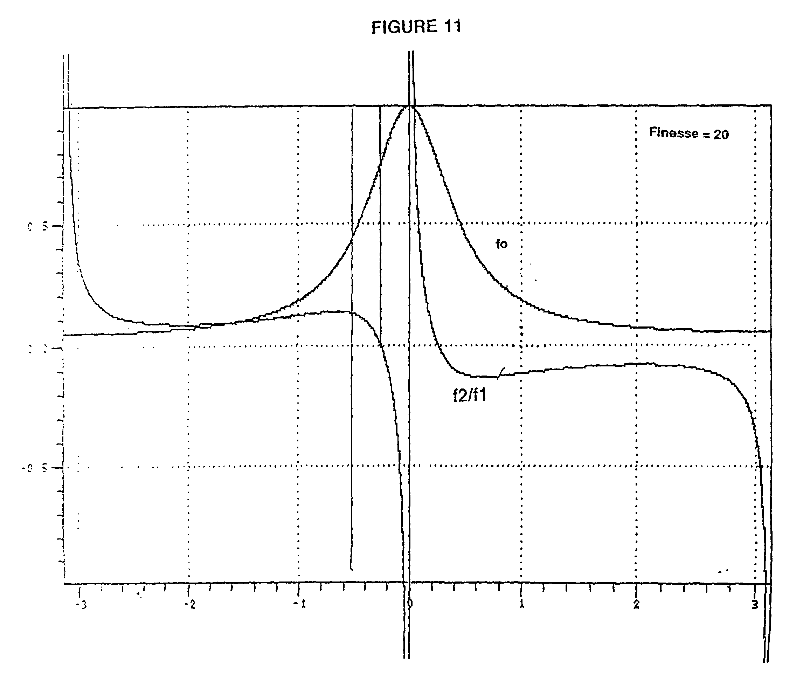

The dither is a low frequency signal which enables the etalon to be adjusted for a predetermined amount of detuning, and thus a certain change in monitored power output. This change is also dependent on the etalon response characteristic and on long term changes in monitoring means (photodiode) and Etalon characteristics, and shorter term changes in input power. The dither is one preferred way of obtaining a change in monitored output. In principle low frequencies in the data being transmitted could be used as these can generate frequency dither. The use of the derivatives enables most of the changes to be accounted for, so that the monitored output is dependent only on the etalon response characteristic. This enables the etalon to be controlled to operate at a particular point on its response curve, such that its dispersion remains constant over long periods, as will now be explained with reference to figures 5 to 11.

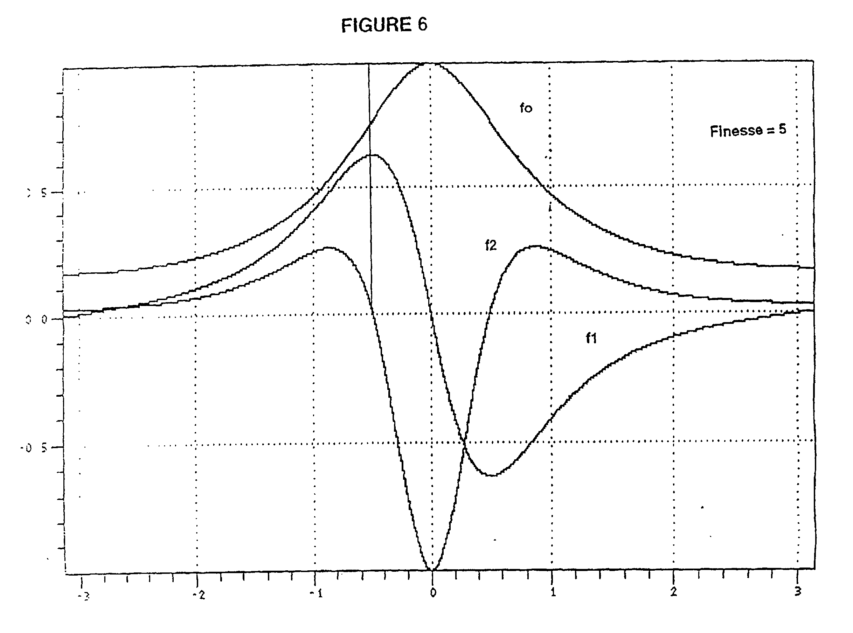

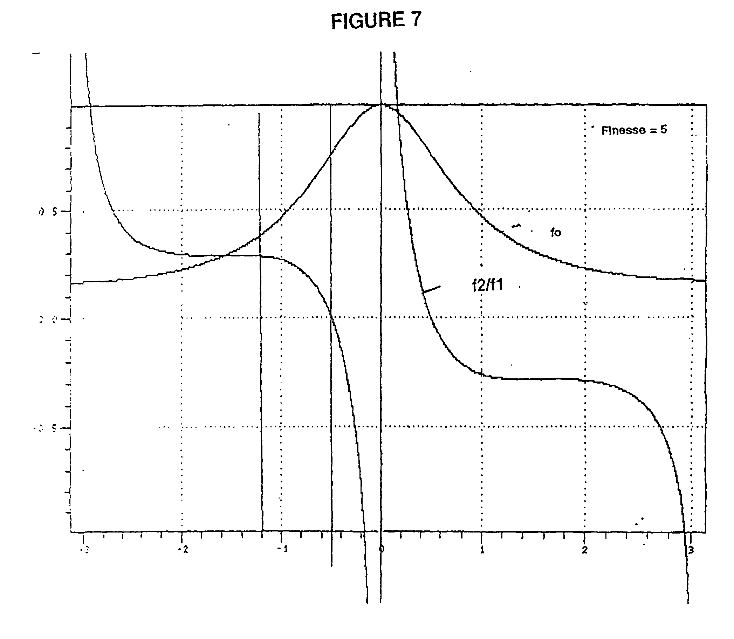

The etalon wavelength response, or transmission characteristic (output power versus detuning in terms of optical wavelength or optical frequency) as given in Hecht, 'Optics', 2nd edition on page 367 (the Airy function) is: A = [1+Fsin²(δ/2]⁻¹ where F = coefficient of finesse of the etalon δ is the phase difference related to the optical path difference between adjacent rays and is a function both of wavelength and the indicated angle of light. This is shown in figure 5 for two different etalons. Figures 6 to 11 also show this response, labelled fo. First and second order derivatives labelled f1 and f2 for an FM dither signal were obtained, with respect to wavelength. All three functions, fo, f1 and f2 were plotted against detuning, in wavelength terms, for different values of the finesse parameter F (F=5,10,20), as shown in figures 6, 8 and 10, respectively. In these figures and figures 7, 9 and 11, the axes are marked with relative dimensions. The first order derivative represents the slope of the response, or delay, and thus represents dispersion directly. The peak of this first order derivative represents the point of maximum dispersion. The second order derivative represents the degree of curvature of the response. Derivative f1 shows a minimum at zero detuning and cannot be used to track the etalon on its own as its magnitude varies with optical power. Derivative f2 shows a zero-crossing at 75% transmission, i.e. the point with highest dispersion. Looking at f2 alone would enable control of the etalon to the point with maximum dispersion.

Normalising f2 with f1 yields a signal that is independent of the input power. These ratios are shown in figures 7, 9 and 11 for different values of the finesse parameter (F=5,/10,/20). The ratio still goes through zero at the maximum dispersion point, but it can also be used to track the etalon to any point between 40% and 100% transmission. To control the side of the resonance the etalon will locking to, the polarity of the f1 signal can be used.

Etalon compensators could be applied at the transmitter, the receiver, or even in principle at the line amplifiers. However use at the line amplifiers is not preferred for the following reason. The Fabry-Perot dispersion varies strongly in both magnitude and sign across the bandwidth of the optical amplifier. It can only be locked to provide the correct dispersion for a specific channel. Other channels would have arbitrary dispersion values, depending on their relative wavelength to the "locked" channel.

In principle a multiplicity of etalons could be used, one locked to each channel, but these would require the each channel to be stripped out and reinserted after equalisation, by the use of WDM splitters and combiners. In practice extensive guard bands would be needed to prevent coherent interference between the residual signal on one path, and the main signal on the other. Use of Fabry-Perot compensators at line amplifiers is not compatible with the line amplifier philosophy of transparency, which means that the line amplifiers should operate on any channel.

When located adjacent to the transmitter laser, there is the option of locking the laser to a fixed spacing compensator (instead of tuning the etalon). This has the advantage of eliminating the piezoelectric elements in the etalon, which present significant reliability concerns over life, temperature and humidity. The etalon could also be used as a high stability passive wavelength reference for the laser. The two techniques could in principle be combined.

When a tracking Fabry-Perot compensator is located at the receiver, the monitor signal for the control loop might be acquired from the system receiver or from a separate monitor detector on the monitor port.

A figure of merit for dispersion equalisers may be defined as
FOM = dispersion (in ps/nm)/loss (in dB).

Group delay measurements can be used directly to calculate the etalon dispersion, bearing in mind that the dispersion as seen by transmitted signal is the averaged value over the signal bandwidth. When averaging over 5 GHz, the dispersion measured for one device was about 1000 ps/nm. Hence, a value of 1000 ps/nm will be used throughout the following calculations of the FOM.

Using an intrinsic loss figure of 0.3 dB for the device, the theoretically achievable FOM with loss-less beam splitter and connectors is 3300 ps/(nm.dB), ignoring slight differences between both channels.

The actually measured loss of one channel including circulator (port 1 to 2 and port 2 to 3) and connectors was 4 dB. Hence the FOM for this channel is 250 ps/(nm.dB).

The measured total loss of the other channel under the same circumstances as before was 2.5 dB. The FOM therefore is 400 ps/(nm.dB).

Wavelength tracking is necessary as the transmission window of the device (-4 GHz) is very narrow. The tracking method of the invention enables the device to be tracked off resonance without depending on the absolute signal power level.

The etalon must be accurately aligned in wavelength with the signal, and a single device can be tuned to align with any wavelength of interest. Using the technique of the invention to lock the etalon to the correct operating point, then a stand-alone solution is feasible. This may be practical using local power monitoring. Integration with the transmitter might enable the piezoelectric actuators to be eliminated. Integration with the receiver would enable the tuning control loop to use eye closure information, and hence provide automatically optimised dispersion compensation.

## Claims

1. A control system for an optial etalon arrangement (4) comprising a pair of reflecting surfaces arranged in parallel, at least one of which is partially reflecting, said partially reflecting surface transmitting a monitoring signal, the control system comprising:
means for monitoring the monitoring signal output power;
a dither generator (5) to apply a dither to the wavelength response of the etalon arrangement (4) or to the wavelength of a signal source (1) upstream of the etalon arrangement; and
means for controlling the wavelength response of the arrangement (3), said means comprising:
a derivative generator (11) for generating first and second order derivatives of the monitoring signal output power, with respect to the wavelength of said monitoring signal; and
an offset generator (12) deriving from the ratio of said derivatives an offset signal, the offset signal adjusting the wavelength response of the arrangement.

2. The system of claim 1 wherein the control system further comprises:
a signal extraction means (10) which extracts a portion of the monitoring signal which is attributable to the dither signal,
wherein the derivative generator (11) generates the derivatives from said portion of the monitoring signal.

3. The system of any proceeding claim, the arrangement being a Fabry Perot etalon dispersion compensator, wherein the control means is operable to maintain the dispersion of the compensator constant.

4. A control system for controlling an output wavelength of a transmitter laser, in an optical transmission system which comprises an etalon arrangement (4) downstream of the laser, as claimed in claim 1.

5. The system of claim 4 wherein the control system further comprises means for applying a wavelength dither to the laser, and the derivatives are obtained from a variation in monitored output caused by the dither.

6. The system of any preceding claim wherein the control means is operable to maintain constant a ratio of a first order derivative and a second order derivative of the wavelength response, at a given wavelength.

7. The system of any proceeding claim wherein the control means is operable to maintain the second derivative at zero.

8. The system of any proceeding claim wherein the control means is operable according to the sign of a first order derivative of the wavelength response.

9. An optical transmission system comprising the transmitter laser, the etalon arrangement and the control system of claim 4 or any of claims 5 to 8 when dependent on claim 4.

10. An etalon arrangement comprising the control system of any of claims 1 to 3, or any claim when dependent on any claims of 1 to 3.

11. A Fabry Perot etalon dispersion compensator comprising:
an etalon arrangement (4) comprising
a pair of reflecting surfaces arranged in parallel, at least one of which is partially reflecting, said partially reflecting surface transmitting a monitoring signal;
means for monitoring the monitoring signal output power;
a dither generator (5) to apply a dither to the wavelength response of the etalon arrangement (4); and
control means to control the wavelength response of the compensator so as to maintain the dispersion of the compensator substantially independent of input power variations and characteristics of the monitoring means, said control means comprising:
a derivative generator (11) for generating first and second order derivatives of the monitoring signal output power, with respect to the wavelength of said monitoring signal; and
an offset generator (12) deriving from the ratio of said derivatives an offset signal, the offset signal adjusting the wavelength response of the arrangement.

12. An optical transmission system comprising the control system of any of claims 1 to 8, or the etalon arrangement of claim 10, or the compensator of claim 11.

13. A method of transmitting data in an optical transmission system comprising a source transmitter (1) and an etalon arrangement (4), the method comprising the steps of:
applying a dither to either the output wavelength of the transmitter or the wavelength response of the etalon arrangement;
monitoring the output power of the etalon arrangement;
calculating a ratio of derivatives with respect to wavelength, of the monitored output; and
generating an offset signal for controlling the output wavelength of the transmitter, or the wavelength response of the etalon arrangement, on the basis of the ratio of the derivatives.

## Patentansprüche

1. Steuersystem für eine optische Etalon-Anordnung (4) mit einem Paar von parallel angeordneten reflektierenden Oberflächen, von denen zumindest eine teilreflektierend ist, wobei die teilreflektierende Oberfläche ein Überwachungssignal überträgt, wobei das Steuersystem folgendes umfaßt:
Einrichtungen zur Überwachung der Überwachungssignal-Ausgangsleistung;
einen Dither-Generator (5) zur Anwendung einer Schwankung auf das Wellenlängen-Ansprechverhalten der Etalon-Anordnung (4) oder auf die Wellenlänge einer Signalquelle (1) in Strahlrichtung vor der Etalon-Anordnung; und
Einrichtungen zur Steuerung des Wellenlängen-Ansprechverhaltens der Anordnung (3), wobei die Einrichtungen folgendes umfassen:
einen Ableitungsgenerator (11) zur Erzeugung von Ableitungen erster und zweiter Ordnung der Überwachungssignal-Ausgangsleistung bezüglich der Wellenlänge des Überwachungssignals; und
einen Offset-Generator (12), der aus dem Verhältnis der Ableitungen ein Offset-Signal ableitet, wobei das Offset-Signal das Wellenlängen-Ansprechverhalten der Anordnung einstellt.

2. System nach Anspruch 1, bei dem das Steuersystem weiterhin folgendes umfaßt:
eine Signalextraktionseinrichtung (10), die einen Teil des Überwachungssignals extrahiert, das dem Schwankungssignal zuzuordnen ist,
worin der Ableitungsgenerator (11) die Ableitungen aus dem Teil des Überwachungssignals erzeugt.

3. System nach einem der vorhergehenden Ansprüche, bei dem die Anordnung ein Fabry-Perot-Etalon-Dispersionskompensator ist, bei dem die Steuereinrichtung so betreibbar ist, daß sie die Dispersion des Kompensators konstant hält.

4. Steuersystem zur Steuerung der Ausgangswellenlänge eines Sender-Lasers in einem optischen Übertragungssystem, das eine Etalon-Anordnung (4) in Strahlrichtung hinter dem Laser umfaßt, wie es in Anspruch 1 beansprucht ist.

5. System nach Anspruch 4, bei dem das Steuersystem weiterhin Einrichtungen zum Anwenden einer Wellenlängen-Schwankung auf den Laser umfaßt, und bei dem die Ableitungen aus einer Änderung des überwachten Ausgangssignals gewonnen werden, die durch die Schwankung hervorgerufen wird.

6. System nach einem der vorhergehenden Ansprüche, bei dem die Steuereinrichtung betreibbar ist, um ein Verhältnis der Ableitung erster Ordnung und der Ableitung zweiter Ordnung des Wellenlängen-Ansprechverhaltens bei einer vorgegebenen Wellenlänge konstant zu halten.

7. System nach einem der vorhergehenden Ansprüche, bei dem die Steuereinrichtung betreibbar ist, um die zweite Ableitung auf Null zu halten.

8. System nach einem der vorhergehenden Ansprüche, bei dem die Steuereinrichtung entsprechend dem Vorzeichen der Ableitung erster Ordnung des Wellenlängen-Ansprechverhaltens betreibbar ist.

9. Optisches Übertragungssystem, das den Sender-Laser, die Etalon-Anordnung und das Steuersystem nach Anspruch 4 oder einem der Ansprüche 5 bis 8 unter Rückbeziehung auf Anspruch 4 umfaßt.

10. Etalon-Anordnung, die das Steuersystem nach einem der Ansprüche 1 bis 3 oder irgendeinem Anspruch unter Rückbeziehung auf einen der Ansprüche 1 bis 3 umfaßt.

11. Fabry-Perot-Etalon-Dispersionskompensator unter Verwendung einer Etalon-Anordnung (4), die folgendes umfaßt:
ein Paar von reflektierenden, parallel angeordneten Oberflächen, von denen zumindest eine teilreflektierend ist, wobei die teilreflektierende Oberfläche ein Überwachungssignal überträgt;
Einrichtungen zur Überwachung der Überwachungssignal-Ausgangsleistung;
ein Schwankungsgenerator (5) zur Anwendung einer Schwankung auf das Wellenlängen-Ansprechverhalten der Etalon-Anordnung (4); und
Steuereinrichtungen zur Steuerung des Wellenlängen-Ansprechverhaltens des Kompensators derart, daß die Dispersion des Kompensators im wesentlichen unabhängig von Eingangsleistungsschwankungen und Charakteristiken der Überwachungseinrichtungen gehalten wird, wobei die Steuereinrichtung folgendes umfaßt:
einen Ableitungsgenerator (11) zur Erzeugung von Ableitungen erster und zweiter Ordnung der Überwachungssignal-Ausgangsleistung bezüglich der Wellenlänge des Überwachungssignals; und
einen Offset-Generator (12), der aus dem Verhältnis der Ableitungen ein Offset-Signal ableitet, wobei das Offset-Signal das Wellenlängen-Ansprechverhalten der Anordnung einstellt.

12. Optisches Übertragungssystem mit dem Steuersystem nach einem der Ansprüche 1 bis 8 oder der Etalon-Anordnung nach Anspruch 10 oder dem Kompensator nach Anspruch 11.

13. Verfahren zur Übertragung von Daten in einem optischen Übertragungssystem, das einen Quellen-Sender (1) und eine Etalon-Anordnung (4) umfaßt, wobei das Verfahren die folgenden Schritte umfaßt:
Anwenden einer Schwankung entweder auf die Ausgangs-Wellenlänge des Senders oder das Wellenlängen-Ansprechverhalten der Etalon-Anordnung;
Überwachen der Ausgangsleistung der Etalon-Anordnung;
Berechnen eines Verhältnisses von Ableitungen bezüglich der Wellenlänge des überwachten Ausgangssignals; und
Erzeugen eines Offset-Signals zum Steuern der Ausgangs-Wellenlänge des Senders oder des Wellenlängen-Ansprechverhaltens der Etalon-Anordnung auf der Grundlage des Verhältnisses der Ableitungen.

## Revendications

1. Un système de commande pour un dispositif étalon optique (4) comprenant une paire de surfaces réfléchissantes disposées de façon parallèle, dont l'une au moins est partiellement réfléchissante, cette surface partiellement réfléchissante transmettant un signal de contrôle, le système de commande comprenant :
des moyens pour contrôler la puissance de sortie du signal de contrôle;
un générateur de variation périodique (5) pour appliquer une variation périodique à la réponse en longueur d'onde du dispositif étalon (4) ou à la longueur d'onde d'une source de signal (1) en amont du dispositif étalon; et
des moyens pour commander la réponse en longueur d'onde du dispositif (3), ces moyens comprenant :
un générateur de dérivées (11) pour générer des dérivées du premier et du second ordre de la puissance de sortie du signal de contrôle, par rapport à la longueur d'onde du signal de contrôle; et
un générateur de décalage (12) élaborant un signal de décalage à partir du rapport de ces dérivées, le signal de décalage réglant la réponse en longueur d'onde du dispositif.

2. Le système de la revendication 1, dans lequel le système de commande comprend en outre :
des moyens d'extraction de signal (10) qui extraient une partie du signal de contrôle qui est attribuable au signal de variation périodique,
dans lequel le générateur de dérivées (11) génère les dérivées à partir de ladite partie du signal de contrôle.

3. Le système de l'une quelconque des revendications précédentes, le dispositif étant un compensateur de dispersion à étalon de Fabry-Pérot, dans lequel on peut faire fonctionner les moyens de commande pour maintenir constante la dispersion du compensateur.

4. Un système de commande pour commander une longueur d'onde de sortie d'un laser d'émetteur, dans un système de transmission optique qui comprend un dispositif étalon (4) en aval du laser, comme énoncé dans la revendication 1.

5. Le système de la revendication 4, dans lequel le système de commande comprend en outre des moyens pour appliquer une variation périodique de longueur d'onde au laser, et les dérivées sont obtenues à partir d'une variation dans le signal de sortie contrôlé, occasionnée par la variation périodique.

6. Le système de l'une quelconque des revendications précédentes, dans lequel les moyens de commande peuvent fonctionner de façon à maintenir constant un rapport entre une dérivée du premier ordre et une dérivée du second ordre de la réponse en longueur d'onde, à une longueur d'onde donnée.

7. Le système de l'une quelconque des revendications précédentes, dans lequel les moyens de commande peuvent fonctionner de façon à maintenir à zéro la dérivée du second ordre.

8. Le système de l'une quelconque des revendications précédentes, dans lequel les moyens de commande peuvent fonctionner en fonction du signe d'une dérivée du premier ordre de la réponse en longueur d'onde.

9. Un système de transmission optique comprenant le laser d'émetteur, le dispositif étalon et le système de commande de la revendication 4 ou de l'une quelconque des revendications 5 à 8, considérées dans la dépendance de la revendication 4.

10. Un dispositif étalon comprenant le système de commande de l'une quelconque des revendications 1 à 3, ou d'une revendication quelconque considérée dans la dépendance de l'une quelconque des revendications 1 à 3.

11. Un compensateur de dispersion à étalon de Fabry-Pérot, comprenant :
un dispositif étalon (4) comprenant
une paire de surfaces réfléchissantes disposées de façon parallèle, dont l'une au moins est partiellement réfléchissante, cette surface partiellement réfléchissante transmettant un signal de contrôle;
des moyens pour contrôler la puissance de sortie du signal de contrôle;
un générateur de variation périodique (5) pour appliquer une variation périodique à la réponse en longueur d'onde du dispositif étalon (4); et
des moyens pour commander la réponse en longueur d'onde du compensateur de façon à maintenir la dispersion du compensateur sensiblement indépendante de variations de puissance d'entrée et des caractéristiques des moyens de contrôle, les moyens de commande comprenant :
un générateur de dérivées (11) pour générer des dérivées du premier et du second ordre de la puissance de sortie du signal de contrôle, par rapport à la longueur d'onde du signal de contrôle; et
un générateur de décalage (12) élaborant un signal de décalage à partir du rapport desdites dérivées, le signal de décalage réglant la réponse en longueur d'onde du dispositif.

12. Un système de transmission optique comprenant le système de commande de l'une quelconque des revendications 1 à 8, ou le dispositif étalon de la revendication 10, ou le compensateur de la revendication 11.

13. Un procédé d'émission de données dans un système de transmission optique comprenant un émetteur source (11) et un dispositif étalon (4), le procédé comprenant les étapes suivantes :
on applique une variation périodique soit à la longueur d'onde de sortie de l'émetteur, soit à la réponse en longueur d'onde du dispositif étalon;
on contrôle la puissance de sortie du dispositif étalon;
on calcule un rapport de dérivées par rapport à la longueur d'onde, du signal de sortie contrôlé; et
on génère un signal de décalage pour commander la longueur d'onde de sortie de l'émetteur, ou la réponse en longueur d'onde du dispositif étalon, sur la base du rapport des dérivées.
